# EUROPEAN PATENT APPLICATION

(11) **EP 4 686 955 A1**
(43) Date of publication of application: **04.02.2026**
(21) Application number: 24191428.2
(22) Date of filing: 29.07.2024
(51) Int. Cl.: G01R 31/396, G01R 31/36

(54) **BATTERY MONITORING SYSTEM**

(71) Applicant: LEM International SA, 1217 Meyrin (CH)
(72) Inventor: NAMOR, Emil, 1304 Cossonay-Ville (CH); SCHLÄFLI, Dominik, 1260 Nyon (CH)
(74) Representative: reuteler & cie SA

(57) **Abstract**

Battery system (100) comprising a plurality of battery cells (101) and a battery management system (104) comprising a battery management unit (106), a current sensor (110) connected to the battery management unit (106) and configured to measure a current flowing in and out a plurality of battery cells (101). The battery system further comprises a battery anomalous condition sensor (1) including an alternating current (AC) measurement sensor (2) configured to measure an alternating voltage of one or more battery cells (101), and a controller (11) configured to process the measured alternating current voltages and either provide said measured alternating voltages to the battery management system (104) to determine an anomalous condition or to process the voltage measurement signal to detect an anomalous condition of the battery and to control a switch (112) to disconnect the battery system (100) from external systems (103) in the case of detection of an anomalous battery condition.

## Description

The present invention relates to a battery monitoring system. The battery monitoring system may in particular be adapted for battery packs for electric vehicles.

Electric batteries for storage and supply of electric power are used in a wide variety of applications, one of the important applications being battery packs for electric vehicles. Typically, a battery system comprises a plurality of battery cells that are connected in series. For instance, in a 400 Volt battery system there are about 100 cells connected in series, each cell having a voltage of about 4 Volts. The assembly of the plurality of cells to generate the required voltage, including the connectors and monitoring electronics and possibly further auxiliary systems such as thermal management systems, is commonly called a battery pack. In some implementations of a battery pack, sub-sets of battery cells are mechanically contained in housings and form what is typically referred to as a battery module. There are however configurations in which there are no separated battery modules but the complete battery pack is formed as a single pack without a modular structure. Irrespective of architecture, all battery packs have a plurality of battery cells connected in series. Battery cells may typically be based on lithium-ion technology however other materials forming battery cells exist and all require some form of battery management to ensure charging and discharging operations in a safe manner. Therefore, battery packs include a battery management system comprising sensors and electronics that are configured to ensure safe and efficient operation of the battery system.

One of the safety requirements of battery systems is to avoid malfunctioning that results in thermal runaway that can lead to fire or explosions. Anomalous conditions that lead to thermal runaway may develop increasingly rapidly and thus require rapid corrective action once detected, in particular the activation of switches to disconnect the battery pack from systems to which it is connected.

Battery management systems include current sensors that are well adapted for measuring the DC current flowing in and out of the battery pack. Anomalous battery conditions however may not be detected rapidly with such sensors. Anomalous conditions generate alternating current (AC) signals, however the fluctuating voltages of the anomalous AC signal is of a very small magnitude compared to the voltage of the DC signal. Monitoring of anomalous conditions with current sensors typically used in battery management systems that are needed for controlling normal conditions in charging and discharging is thus not optimal and would require costly sensing systems to be able to measure both the slowly changing DC currents with a high dynamic raange during normal operation as well as detecting AC currents at anomalous conditions.

In order to detect specifically thermal runaway conditions it is known to employ gas and pressure sensors that detects gas production by the battery during thermal runaway. Such systems allow the battery management system to have simpler and lower cost current sensors for normal operation and a separate sensing system specifically for thermal runaway. One of the problems of gas and pressure sensors however is that thermal runaway is detected at a rather late stage whereby the anomalous conditions leading to thermal runaway may occur minutes before any excessive gas production has occurred. Also, gas and pressure sensors require air-tight battery enclosures in order to be able to detect the pressure changes.

In view of the foregoing, it is an object of this invention to provide a battery monitoring system that enables rapid detection of anomalous battery conditions and in particular a thermal runaway condition in a reliable, safe and cost-effective manner.

It is advantageous to provide a battery monitoring system that may be easily integrated into existing battery pack architectures.

It is advantageous to provide a battery monitoring system that is easy to control.

Objects of this invention have been achieved by providing a system according to claim 1. Dependent claims set forth various advantageous features of embodiments of the invention.

Disclosed herein is a battery anomalous condition sensor for integration in a battery system, the battery system comprising a plurality of battery cells and a battery management system, a current sensor connected to the battery management system and configured to measure a current flowing in and out a plurality of battery cells, wherein the battery anomalous condition sensor includes an alternating current measurement sensor configured to measure an alternating voltage of one or more battery cells, and a controller configured to process the measured alternating current voltages and either provide said measured alternating voltages to the battery management system to determine an anomalous condition, or to process the voltage measurement signal to detect an anomalous condition of the battery and to control a switch to disconnect the battery system from external systems in the case of detection of an anomalous battery condition.

Also disclosed herein is a battery system comprising a plurality of battery cells and a battery management system comprising a battery management unit, a current sensor connected to the battery management unit and configured to measure a current flowing in and out a plurality of battery cells, wherein the battery system further comprises a battery anomalous condition sensor including an alternating current (AC) measurement sensor configured to measure an alternating voltage of one or more battery cells, and a controller configured to process the measured alternating current voltages and either provide said measured alternating voltages to the battery management system to determine an anomalous condition or to process the voltage measurement signal to detect an anomalous condition of the battery and to control a switch to disconnect the battery system from external systems in the case of detection of an anomalous battery condition.

In an advantageous embodiment, the AC measurement sensor comprises a Rogowski current transducer, or a current transformer

In an advantageous embodiment, the controller of the battery anomalous condition sensor further comprises a micro-controller configured for processing measurement signals from the AC sensor.

In an advantageous embodiment, the AC measurement sensor comprises a plurality of voltage connection points connected to groups of battery cells via a DC filter to a voltage measurement signal conditioning circuit of the controller.

In an advantageous embodiment, the battery anomalous condition sensor comprise an AC signal conditioning circuit connected downstream of the AC measurement sensor, the AC signal conditioning circuit and voltage measurement signal conditioning circuit connected to an analog to digital converter (ADC).

In an advantageous embodiment, the AC measurement signal processing circuit further comprises a multiplexer connected upstream to the analog to digital converter for processing a plurality of voltage measurement signals from the AC sensor.

In an advantageous embodiment, the battery system further comprises output signal processing software installed in the controller or in the battery management system configured for measuring an impedance with an impedance measurement algorithm and determining an anomalous battery condition by an anomalous condition measurement algorithm.

In an advantageous embodiment, the controller is connected to the switch of the battery management system or to a dedicated switch of the battery anomalous condition sensor, the switch connected in series to an input/output conductor of the battery system, the battery anomalous condition sensor configured to open said switch in case of an anomalous condition determined by the output signal processing software.

Further objects and advantageous features of the invention will be apparent from the claims, from the detailed description, and annexed drawings, in which:

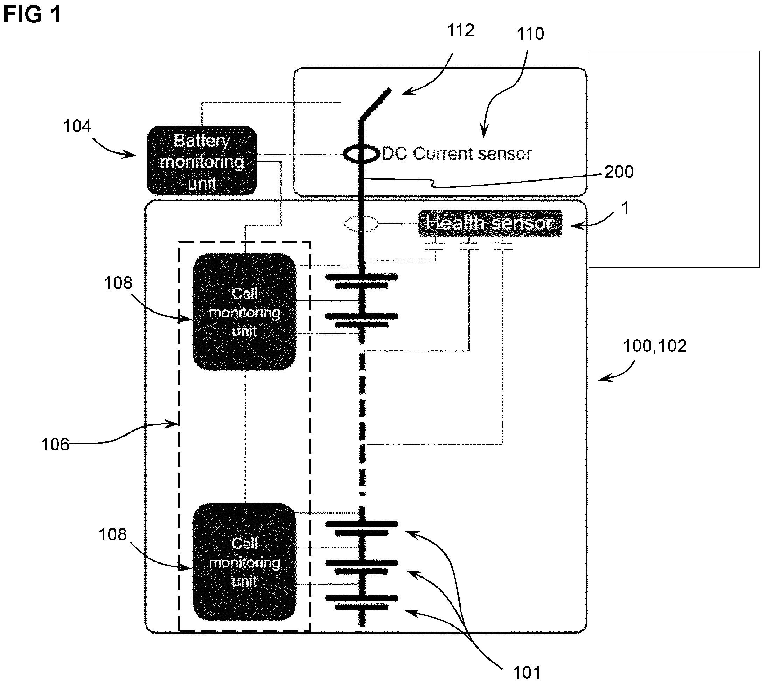

Figure 1 is a schematic overview diagram of a battery system including a battery monitoring system according to an embodiment of the invention;

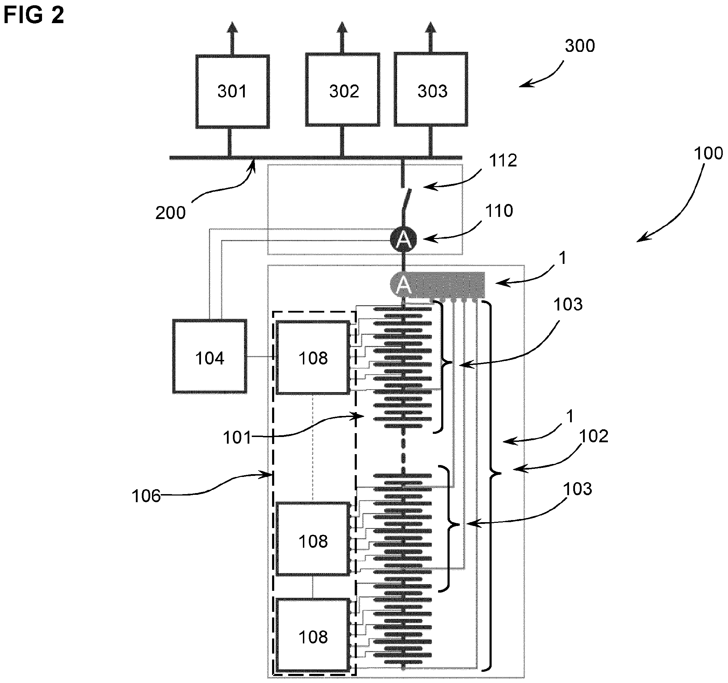

Figure 2 is a schematic overview of a battery system including a battery monitoring system according to an embodiment of the invention, connected to components of an electrical system via a high voltage bus;
Figure 3a to 3d are plots of the complex impedance of a battery showing the real value and imaginary value of a voltage response relative to an injected AC current, figure 3a illustrating a general shape of a response curve, figure 3b different response curves for different operating temperatures, figure 3c different response curves for different numbers of charging cycles, and figure 3d different curves for different temperatures;

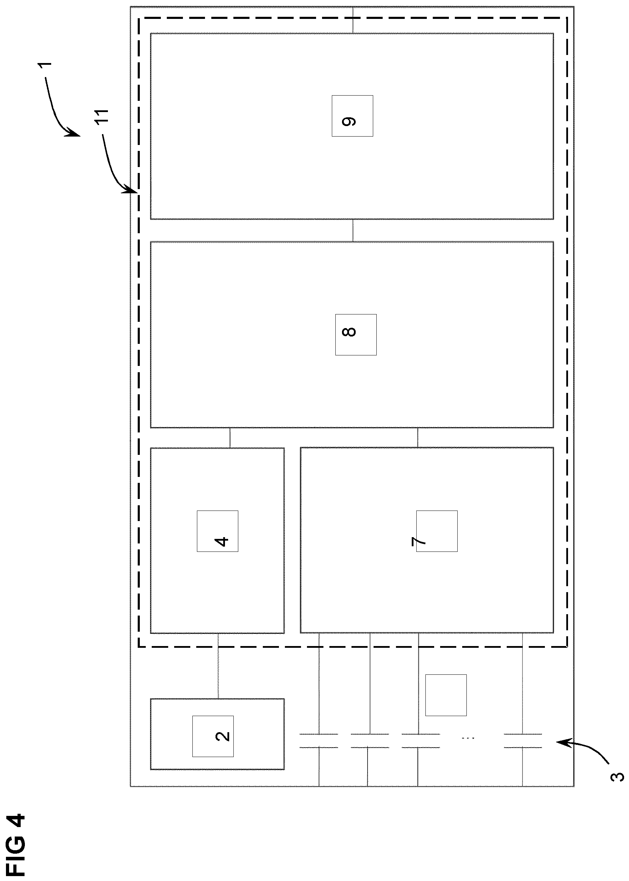

Figure 4 is simplified block diagram showing components of a battery monitoring system according to an embodiment of the invention;
Figure 5 is a simplified block diagram of a software module of a battering monitory system according to an embodiment of the invention;
Figure 6 is a simplified flow diagram illustrating an example of steps carried out by the software module for detecting anomalous battery conditions according to an embodiment of the invention;

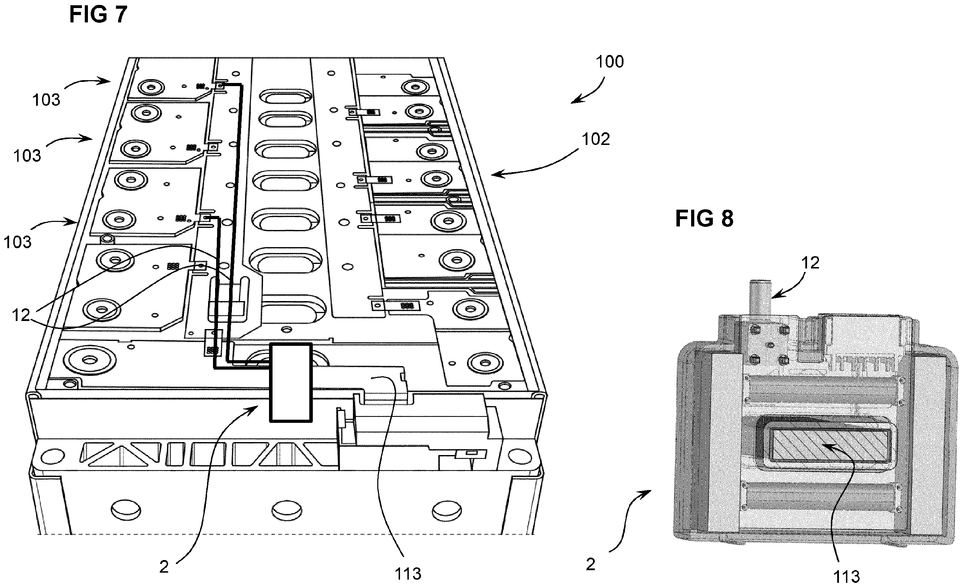

Figure 7 is an illustration of a battery system including a battery pack and a battery anomalous condition sensor according to an embodiment of the invention;
Figure 8 is a cross-sectional view of an alternating current sensor of a battery anomalous condition sensor according to an embodiment of the invention.

Referring to the figures, a battery system 100 comprises a battery pack 102 including a plurality of battery cells 101 connected in series, either to form a single battery pack or arranged in battery modules 103 that are interconnected together in series.

The battery system further comprises a battery management system 104 comprising a battery management unit 106 that may include a plurality of cell monitoring units 108, the battery management system further comprising a current sensor 110 measuring the current flowing in and out of the battery pack 102. The cell monitoring units 108 monitor the voltages of all cells within a battery system. Typically, each cell monitoring unit may monitor up to 20 cells. All voltage measurements are communicated to the battery management system 104. The current flowing through the battery pack is measured by a current sensor 110 and the measurement value communicated to the battery management system 104.

The battery management system 104 further comprises a switch 112 to disconnect the battery system 100 from external devices 300 to which the battery pack is connected. In the case for instance of an electrical vehicle the battery system 100 may be connected via a high voltage bus 200 to power electronic devices 300 including for instance an inverter 301, a high voltage/low voltage DC/DC converter 302, an onboard charger 303 and low voltage auxiliary systems (not represented). The power electronic devices 300, high voltage bus 200 and battery system 100 are per se known and do not need to be described in detail herein.

The battery management system includes a microcontroller that executes battery diagnostic functions based on the voltage and current measurements among others.

The battery system according to embodiments of the invention further comprises a battery anomalous condition sensor 1. The battery anomalous condition sensor 1 is preferably implemented in each battery pack 102 and optionally in each battery module and may be connected to the switch 112 of the battery management system 104 or a dedicated switch separate from the switch of the battery management system.

The battery anomalous condition sensor 1 may be further connected to the battery management system 104 providing measurement data to the battery management system 104 during normal operation.

The battery anomalous condition sensor 1 comprises an alternating current (AC) sensor and a dedicated AC sensor controller 11. The AC sensor controller comprises an AC signal conditioning circuit 4, a voltage measurement signal conditioning circuit 7, an analog to digital converter (ADC) 8, and a micro-controller 9.

The AC sensor controller may further comprise measurement signal processing software 10 installed therein including an impedance measurement algorithm 10a and an anomalous condition measurement algorithm 10b to process the measurement signals output by the AC sensor 2. If the output signal processed by the output signal processing software detects an anomalous condition representative of a possible thermal runaway, the battery anomalous condition sensor may activate opening of the switch 112 of the battery management system 104, or of a separate dedicated switch connected to the battery anomalous condition sensor 1 if present.

In an alternative embodiment, the AC sensor controller may be connected to the battery management unit 106 outputting the measurement signal from the AC sensor 2 whereby the output signal processing software 10 is integrated in the battery management system 104 that controls the switch 112.

The battery anomalous condition sensor 1 comprises an alternating current sensor 2 that is configured to measure principally or solely alternating current signals. In a preferred embodiment, the alternating current sensor 2 comprises a Rogowski current transducer, or a current transformer, such transducers being *per se* well known and configured for measuring alternating currents.

The AC sensor 2 is mounted around a battery pack connection line 113 to measure the alternating current flowing in and out of the battery pack. The AC sensor 2 further comprises a plurality of voltage measurement lines 12 configured for measuring the alternating current voltage about one or a plurality of battery cells 101. Preferably, the voltage measurement lines are connected to a plurality of battery cells 101 connected in series, the plurality of battery cells being monitored in series being optimized for sufficient measurement signal strength and measurement resolution to detect which group of battery cells are defective. Preferably, if the battery pack is made of a plurality of battery modules 103, there may be one voltage measurement sensing line per one or more battery modules.

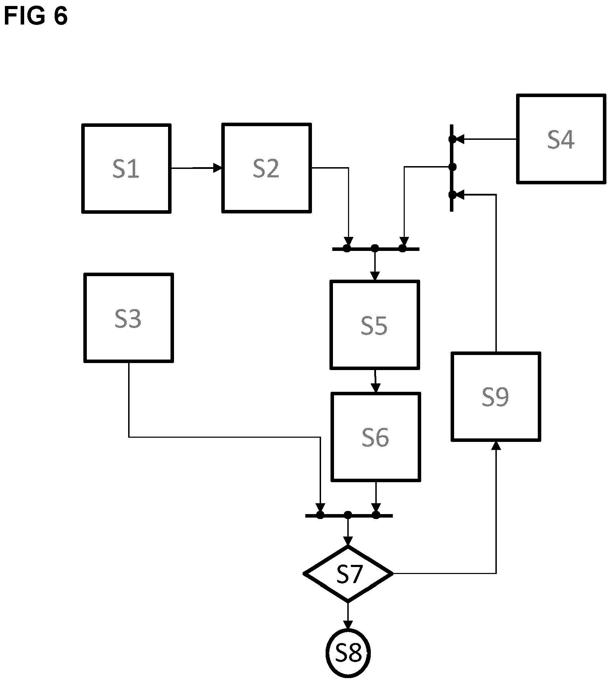

The number of voltage measurements shall be as low as possible as to minimize the cost of the device. At the same time, the number of measurements shall be high enough that an abnormal change in the impedance of one cell produces a measurable change in the impedance of the series of cells including it. At one extreme, only the total battery system voltage is measured. In this case, the cost is minimum, but an abnormal change in impedance of one cell may not produce a change in the total system impedance that can be detected. In an opposite implementation, all cells' voltages are measured. In this case, the ability of detecting an abnormal impedance change is maximum, but the cost is also maximum. A number of battery cells 101 connected in series and connected to a voltage measurement point may be determined according to an example procedure illustrated in figure 6 and set out below in steps S1 to S9:
1. Determine which impedance based battery diagnostic method is used, since per se known methods exist and the implemented method determines which feature of the impedance spectrum is to be observed and which change in this feature is meaningful for diagnostic purposes
2. Determine which resolution is necessary in the voltage measurement of one cell to detect an abnormal behaviour in the cell impedance.
3. Determine which resolution can be obtained with a determined voltage sensing circuit.
4. Set the initial number of voltage measurement circuits to one, i.e. on measurement for the pack voltage.
5. Determine the number of cells per voltage measurement circuit as the ratio between total number of cells and number of voltage measurement circuits.
6. Divide the resolution needed per cell per the number of cells monitored by each sensing circuit to obtain the resolution needed per each series of cells
7. Compare the resolution needed per series of cells and the resolution of the voltage measurement circuit.
8. If the resulting resolution is lower than the resolution of the voltage sensing circuit, stop.
9. If the resulting resolution is higher than the resolution of the voltage sensing circuit, increase by one the number of voltage measurement circuits and go back to step 5.

The AC sensor 2 may be connected to the voltage measurement points via high pass filters 3 that may simply comprise DC filters in the form of capacitors. In an embodiment, the electronic circuit of the battery anomalous condition sensor 1 thus includes :
> an AC current measuring element, and a number of capacitors connected to the inputs at which the voltage of different battery segments are connected, whereby the role of these capacitors is to filter out the DC and low frequency part of said voltages;
> an AC signal conditioning circuit 4 for the signal conditioning of the AC current measurement issued by the AC current measuring element, which may include, for instance, a low pass filter that dampens high frequency spike signals if the AC current sensing element is a Rogowski coil, and an amplifier;
> a voltage measurement signal conditioning circuit 7 for the signal conditioning of the voltage measurement, which may include a resistor to create a high pass filter together with the capacitor so to determine a transfer function that eliminates the DC part of the voltage signal, and might also include an amplifier;
> an analog to digital converter (ADC) 8 that executes the conversion of the signals output by the AC signal conditioning circuit 4 and the voltage measurement signal conditioning circuit 7 from analog to digital (ADC), which may include a multiplexer and one or more analog-to-digital converters - for instance each input to this stage might be converted simultaneously by dedicated ADC channels, or all inputs might be provided to a multiplexer and converted sequentially by the ADC or all voltage measurement inputs might be provided to a multiplexer and converted by the ADC sequentially and the current might be provided to a separate ADC for conversion;
> and a micro-controller 9 executing some digital processing of said measurement and communicating its input to an external controller, such as the microcontroller of the battery management system 104.

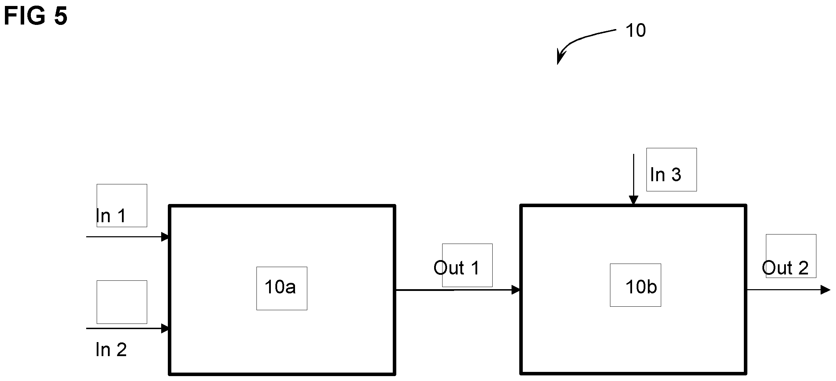

A digital process, for instance as schematically illustrated in figure 5, exploits the current and voltage measurements to generate a battery diagnostic. The process may comprise for instance the following two steps:
First Step:
   > The first step gets as inputs the time-domain data In1, In2 of the current flowing through a battery segment, for instance a battery module 3, formed by a plurality of battery cells 101 connected in series and the voltage of said battery segment;
   > an impedance measurement algorithm 10a of measurement signal processing software 10 executed in the micro controller 9 of the battery anomalous monitoring system or executed in the battery management system processes this time-domain data In1, In2 and provides as output the complex impedance of said battery segment;
   > the aforementioned impedance measurement may be executed at a predetermined frequency or frequencies selected based on a chosen battery diagnostic objective;
   > the complex impedance calculation may include the computation of frequency-domain signals via, for instance a fast Fourier transform or a Goertzel algorithm, the selection of the signal at the desired frequency and the division of the value of the voltage by the value of the current.
Second step:
   > a second step comprises executing an anomalous condition measurement algorithm 10b of measurement signal processing software 10 executed in the micro controller 9 of the battery anomalous monitoring system or executed in the battery management system, from the impedance of the battery segments output by the previous step, eventually together with other inputs In3 such as values of temperatures or battery states, and providing as output a state of the battery or a warning for abnormal behaviour of the battery segment - this step may rely on look-up tables, battery models, and/or artificial intelligence algorithms. Moreover, it might trigger the warning output based on deviation of the battery segment impedance from expected value, rate of change of battery segment impedance or divergence of one or more battery segment impedances from other battery segment impedances.

An embodiment of this invention may process both these steps in the battery anomalous condition sensor 1 and communicate the battery diagnostic value or warning to the battery management system 104. Another embodiment of this invention may execute only the first step of this process in the battery anomalous condition sensor 1 and communicate to the battery management system 104 the value of complex impedance. The task of deriving a battery diagnostic or warning in this alternative embodiment is carried out by the battery management system 104.

In summary, in embodiments of the invention, the battery anomalous condition sensor i) measures an AC component of the current flowing in a high voltage battery pack,
ii) measures the AC component of a number of voltages within the battery pack,
iii) from said current and voltage measurements determines the complex value of the AC impedance of portions of the battery pack and
iv) determines from said AC impedance a diagnostic value of the health of each portion of the battery pack, either to determine the state of health or to detect faulty conditions of the battery, leading to the risk of battery thermal runaway.

The advantage of the invention over other state of the art methods for battery current sensing is that its measurements are limited to the AC component of the battery current and voltages, allowing for greater resolution than other methods from the state of the art.

With respect to gas and pressure sensors, the proposed invention has the following advantages:
a. thermal runaway can be detected minutes before any venting has happened yet
b. no requirement on the airtightness of the battery mechanical enclosure
c. additional functions such as SOH tracking or Lithium-plating detections are possible

With respect to battery management system (BMS) based measurements, the proposed invention:
a. focuses on AC signals only, thus benefiting from a larger dedicated range and resolution, whereas battery management system measurements include both DC and AC, whereby, the DC signals occupy most of the available acquisition range, thus limiting the resolution for the AC signals needed for impedance.
b. does not require high communication bandwidth or tight time synchronization among independent components. In BMS-based measurement solutions, current measurement data from a DC current sensor and voltage measurements from cell monitoring units must be communicated with high bandwidth and synchronicity to the battery monitoring unit
c. includes measurement and signal processing in a unique device

Knowledge of battery impedance enables early detection of battery thermal runaway as well as other battery diagnostic applications, such as state of health estimation. Measurement of AC impedance in high voltage (HV) battery packs is challenging because the necessary AC signals are superimposed to large DC signals:
- the system voltage reaches 400 or 800 V DC (by the sum of about 100 or 200 cells, having about 4 V each).
- the system current is variable and up to about 1500 A.

Therefore, to measure AC impedance, relatively small AC signals (up to few tens of Amperes and few hundred millivolts) superimposed to large DC biases must be measured. State of the art BMS measure DC values and thus they are not suited for measuring the AC signals used in electrochemical impedance spectroscopy (EIS).

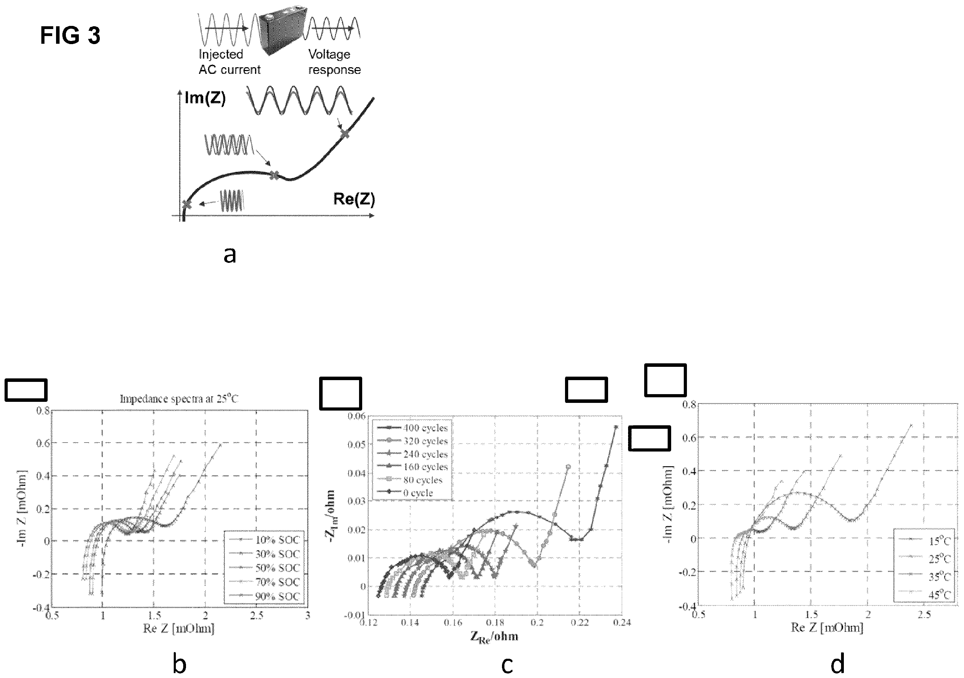

Electrochemical impedance spectroscopy (EIS) is a technique used to characterize electrochemical systems, such as batteries. It includes injecting AC current signals of a set of frequencies into the system and measuring the voltage response. From these current and voltage data the complex impedance at each frequency is computed and a spectrum is created, see Figure 3a.

This spectrum changes based on the state of the electrochemical system, based for instance on its state of charge, state of health or internal temperature, see Figure 3b, 3c and 3d respectively. Conventionally, the frequency range of interest for batteries is between 10 mHz an 10 kHz. The current is typically modulated so to obtain a voltage response with absolute magnitude around 10 mV. Larger currents may cause the device-under-test to behave nonlinearly, while lower currents may not cause voltage oscillations large enough to get acceptable signal-over-noise ratios. The magnitude of impedance for automotive batteries is in the milliohm range.

EIS is conventionally used in laboratory settings and only recently efforts have been made to implement such techniques onboard of electric vehicles batteries with the objective to enhance the diagnostic capability of battery management systems and thus improving the performance of the battery system.

One possible implementation of onboard EIS discussed in prior art consists in controlling one of the power electronic devices connected to the high-voltage bus 200 to inject a current ripple at a desired frequency into the battery 100. The existing BMS infrastructure could in principle be used to measure the AC current signal, the cell voltages and compute the impedance. Notably, the current sensor 110 measures the current, the CMUs 108 measure the cell voltages and the BMS 104 computes the cell impedance based on such values.

While valid in principle, this approach has not yet been widely adopted, due to the absence of components with the necessary specifications.

For instance, CMUs108 typically measure the cell voltages with accuracy of 1 or 2 mV and communicates the values to the BMS 104 every 100 ms (i.e. 10 Hz). This is enough to satisfy the conventional functions of CMUs (e.g. DC voltage measurement of a voltage between 2.7 and 4.2 V) but is not enough to carry out EIS. A typical voltage oscillation generated in EIS is of about 10 mV, thus the CMU 108 needs to measure with at least 100 µV resolution. Similarly, the frequencies of interest for battery diagnosis via EIS are often up to 1 or 10 kHz. Therefore, to execute EIS on the BMU, data should be communicated with a rate in the tens of kHz. A similar improvement in accuracy, bandwidth and communication speed is required for the current sensor. Moreover, the communication busses between all these components should sustain a higher traffic and the measurements of voltage and current should be executed synchronously.

The present invention overcomes the drawback that the onboard EIS method previously described cannot be efficiently implemented without improving the BMS in several areas (accuracy, communication, synchronisation). The BMS is a device originally conceived for the measurement of large, slow, DC signals. As proposed with the current invention, the BMS may focus for slow DC measurements and the dedicated battery anomalous monitoring sensor may be purposefully dedicated to the measurement of fast an small AC signals within the battery. This would include measurement of the AC part of the battery current relevant for EIS, measurement of a number of AC voltages relevant for EIS, sampling of these quantities at a high rate and in a synchronized manner, computation of the complex impedance and communication of this value to BMS at a lower rate (e.g. 100 ms).

The advantages of embodiments of the invention are thus:
- No synchronization is needed across different devices
- No high-rate communication is needed across devices
- Both voltage and current measurement front-ends can be purposefully optimized for the EIS function (i.e. measurement of fast and small AC signals), rather than carrying out two functions with different requirements
- High-performance requirements are removed from the expensive set of devices composing the BMS, thus potentially reducing its price. The expected cost reduction of the expensive BMS is higher than the additional cost of the proposed device.
- The overall system is made more modular and more future-proof. For instance, future li-ion cells might have lower internal impedance (reduced losses). Thus, increased resolution will be needed for the impedance measurement function. A system in which this function is executed by the proposed device can be updated more easily than a system where this function is carried out via the BMS.

### List of references used

**Power electronic devices 300**
   Inverter
   HV/LV DC/DC Converter
   Low voltage auxiliary systems
   On-board charger
**High voltage bus 200**
**Battery system 100**
   Battery cell 101
   Battery pack 102
      Battery module 103
   Battery input/output conductor 113
   **Battery management system 104**
      Battery management unit 106
         Cell monitoring unit 108
      Current sensor 110
      Switch 112
**Battery anomalous condition sensor 1**
   AC sensor 2
      Rogowski current transducer
      Voltage measurement input 12
   High pass filter
      DC filter 3
      Capacitors
   AC sensor controller 11
      AC signal conditioning circuit 4
         Low pass filter 5
         Amplifier 16
      Voltage measurement signal conditioning circuit 7
         High pass filter
         amplifier
      Analog to Digital Converter (ADC) 8
         Multiplexer
      Microcontroller 9
      Output signal processing software 10
         (Complex) impedance measurement algorithm 10a
         Anomalous condition measurement algorithm 10b

## Claims

1. Battery system (100) comprising a plurality of battery cells (101) and a battery management system (104) comprising a battery management unit (106), a current sensor (110) connected to the battery management unit (106) and configured to measure a current flowing in and out a plurality of battery cells (101), **characterized in that** the battery system further comprises a battery anomalous condition sensor (1) including an alternating current (AC) measurement sensor (2) configured to measure an alternating voltage of one or more battery cells (101), and a controller (11) configured to process the measured alternating current voltages and either provide said measured alternating voltages to the battery management system (104) to determine an anomalous condition or to process the voltage measurement signal to detect an anomalous condition of the battery and to control a switch (112) to disconnect the battery system (100) from external systems (103) in the case of detection of an anomalous battery condition.

2. The battery system of claim 1 wherein the AC measurement sensor (2) comprises a Rogowski current transducer, or a current transformer

3. The battery system of any preceding claim wherein the controller (11) of the battery anomalous condition sensor further comprises a micro-controller (9) configured for processing measurement signals from the AC sensor (2).

4. The battery system of any preceding claim wherein the AC measurement sensor comprises a plurality of voltage connection points connected to groups of battery cells (101) via a DC filter to a voltage measurement signal conditioning circuit (7) of the controller.

5. The battery system of any preceding claim wherein the battery anomalous condition sensor comprise an AC signal conditioning circuit (4) connected downstream of the AC measurement sensor, the AC signal conditioning circuit (4) and voltage measurement signal conditioning circuit (7) connected to an analog to digital converter (ADC) (8).

6. The battery system according to any preceding claim wherein the AC measurement signal processing circuit further comprises a multiplexer connected upstream to the analog to digital converter (8) for processing a plurality of voltage measurement signals from the AC sensor.

7. The battery system of any preceding claim further comprising output signal processing software (10) installed in the controller (11) or in the battery management system (104) configured for measuring an impedance with an impedance measurement algorithm (10a) and determining an anomalous battery condition by an anomalous condition measurement algorithm (10b).

8. The battery system of any preceding claim wherein the controller (11) is connected to the switch (112) of the battery management system or to a dedicated switch of the battery anomalous condition sensor, the switch connected in series to an input/output conductor of the battery system (100), the battery anomalous condition sensor (1) configured to open said switch in case of an anomalous condition determined by the output signal processing software (10).

9. A battery anomalous condition sensor (1) for integration in a battery system (100), the battery system comprising a plurality of battery cells (101) and a battery management system (104), a current sensor (110) connected to the battery management system (104) and configured to measure a current flowing in and out a plurality of battery cells (101), **characterized in that** the battery anomalous condition sensor (1) includes an alternating current measurement sensor (2) configured to measure an alternating voltage of one or more battery cells (101), and a controller (11) configured to process the measured alternating current voltages and either provide said measured alternating voltages to the battery management system (104) to determine an anomalous condition, or to process the voltage measurement signal to detect an anomalous condition of the battery and to control a switch (112, 113) to disconnect the battery system (100) from external systems (103) in the case of detection of an anomalous battery condition.

10. The battery anomalous condition sensor of the preceding claim wherein the AC measurement sensor (2) comprises a Rogowski current transducer, or a current transformer

11. The battery anomalous condition sensor of any preceding claim 9-10 wherein the controller (11) of the battery anomalous condition sensor further comprises a micro-controller (9) configured for processing measurement signals from the AC sensor (2).

12. The battery anomalous condition sensor of any preceding claim 9-11 wherein the AC measurement sensor comprises a plurality of voltage connection points for connection to groups of battery cells (101) via a DC filter to a voltage measurement signal conditioning circuit (7) of the controller.

13. The battery anomalous condition sensor of any preceding claim 9-12 comprising an AC signal conditioning circuit (4) connected downstream of the AC measurement sensor, the AC signal conditioning circuit (4) and voltage measurement signal conditioning circuit (7) connected to an analog to digital converter (ADC) (8).

14. The battery anomalous condition sensor of any preceding claim 9-13 wherein the AC measurement signal processing circuit further comprises a multiplexer connected upstream to the analog to digital converter (8) for processing a plurality of voltage measurement signals from the AC sensor.

15. The battery anomalous condition sensor of any preceding claim 9-12 further comprising output signal processing software (10) installed in the controller (11) configured for measuring an impedance with an impedance measurement algorithm (10a) and determining an anomalous battery condition by an anomalous condition measurement algorithm (10b).

16. The battery anomalous condition sensor of any preceding claim 9-15 wherein the controller (11) is configure to be connected to the switch (112) of the battery management system or to a dedicated switch of the battery anomalous condition sensor, the switch connected in series to an input/output conductor of the battery system (100), the battery anomalous condition sensor (1) configured to open said switch in case of an anomalous condition determined by the output signal processing software (10).
